# FASCICULE DE BREVET EUROPEEN

(11) **EP 1 067 672 B1**
(45) Date de publication et mention de la délivrance du brevet: **01.12.2004**
(21) Numéro de dépôt: 00401631.7
(22) Date de dépôt: 08.06.2000
(51) Int. Cl.: H03B 5/18

(54) **Oscillateur hyperfréquence à résonateur diélectrique**
Oszillator mit dielectrischem Resonator
Dielectric Resonator Oscillator

(30) Priorité: 01.07.1999 FR 9908458
(43) Date de publication de la demande: 10.01.2001
(73) Titulaire: ALCATEL, 75008 Paris (FR)
(72) Inventeur: Martheli, Michel, 95180 Menucourt (FR); Pinchon, Alain, 95490 Vaureal (FR); Beuzer, Michel, 91260 Juvisy sur Orge (FR)
(74) Mandataire: Lamoureux, Bernard

(56) Documents cités:
- EP-A- 0 247 749
- EP-A- 0 250 301
- FR-A- 2 533 777
- PATENT ABSTRACTS OF JAPAN vol. 006, no. 037 (E-097), 6 mars 1982 (1982-03-06) & JP 56 156002 A (MURATA MFG CO LTD), 2 décembre 1981 (1981-12-02)
- LEE K W ET AL: "PUSH-PUSH, FREQUENCY-DOUBLING, MMIC OSCILLATORS" PROCEEDINGS OF THE GALLIUM ARSENIDE INTEGRATED CIRCUIT SYMPOSIUM (GAAS IC),US,NEW YORK, IEEE, vol. SYMP. 9, 1987, pages 227-230, XP000430893
- LAN G ET AL: "ULTRASTABLE LOW-NOISE GAAS FET OSCILLATOR WITH DIELECTRIC RESONATOR" RCA REVIEW,US,RCA CORP. PRINCETON, vol. 47, no. 4, 1 décembre 1986 (1986-12-01), pages 472-486, XP000001951

## Description

L'invention est relative à un oscillateur hyperfréquence à résonateur diélectrique.

Les oscillateurs de ce type sont couramment utilisés en électronique dans le domaine des hyperfréquences. Ils constituent des composants de base de nombreux circuits notamment dans le domaine de la télévision ou des télécommunications.

Un tel oscillateur comprend une partie active à amplificateur ou impédance négative et une partie passive comportant le résonateur diélectrique.

La partie active et la partie passive peuvent être associées en réflexion ou en transmission.

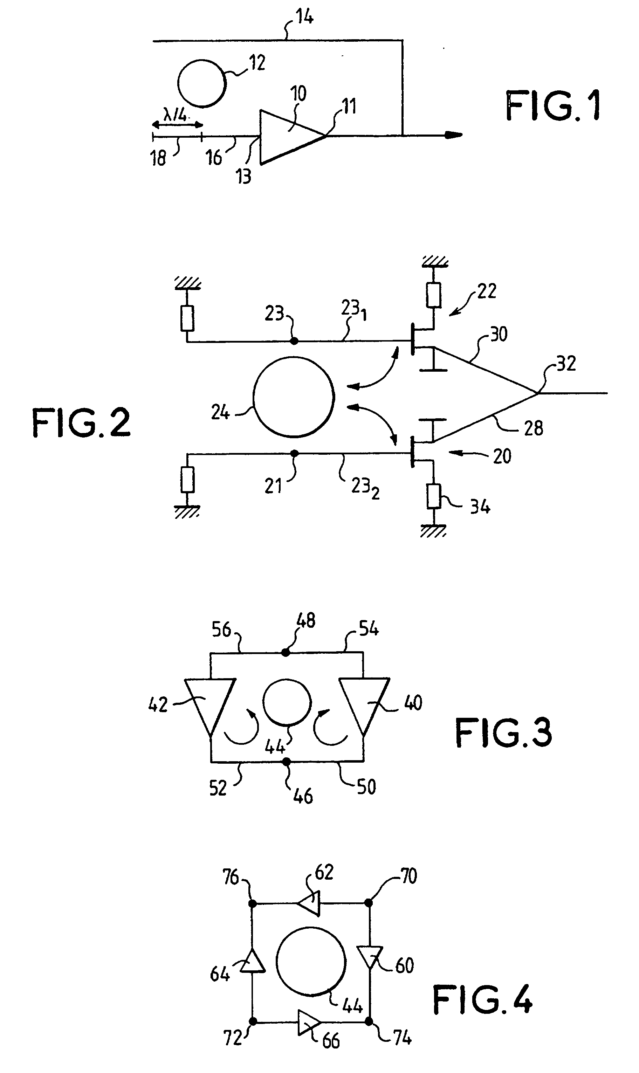

La figure 1 montre un montage connu en transmission.

Dans ce montage, l'élément actif est constitué par un amplificateur 10 et le résonateur diélectrique 12 se trouve en série dans une boucle de rétrocouplage reliant la sortie 11 de l'amplificateur 10 à son entrée 13.

La liaison entre la ligne 14, connectée à la sortie 11 de l'amplificateur 10, et le résonateur 12 est un couplage de type magnétique. De même, le couplage entre la ligne d'entrée 16 et le résonateur 12 est de type magnétique. Le couplage entre le résonateur 12 et chacune des lignes 14,16 est donc d'autant plus élevé que le courant dans la ligne est important. C'est pourquoi, on prévoit en général une ligne 18 de longueur λ/4 à l'entrée pour réaliser un court-circuit et donc maximiser le courant. λ est la longueur d'onde correspondant à la fréquence de l'oscillateur.

Pour réaliser un tel oscillateur, il faut classiquement satisfaire à deux conditions, à savoir, d'une part, que le gain de l'amplificateur 10 soit supérieur aux pertes du circuit de rétroaction entre la sortie 11 et l'entrée 13 et, d'autre part, que le déphasage des signaux à travers le circuit soit nul, modulo 2π. Pour satisfaire à la seconde condition, les points de couplage des conducteurs 14 et 16 au résonateur 12 sont, par exemple, diamétralement opposés par rapport au résonateur en forme de disque. Dans ces conditions, le résonateur introduit un déphasage π radians, et l'amplificateur 10 ainsi que les lignes associées introduisent le déphasage complémentaire de π radians.

Ce type d'oscillateur présente l'avantage d'une grande reproductibilité : il se prête ainsi à une fabrication en série car il nécessite peu de réglages. Par contre, sa mise au point n'est pas toujours aisée car deux couplages sont à déterminer : le couplage entre le résonateur et les lignes 14 et 16. En outre, comme pour réaliser le court-circuit, il est nécessaire de prévoir une ligne 18 de longueur fonction de la longueur d'onde, la bande passante du circuit associé est donc faible.

Le document JP56156002 décrit un oscillateur à résonateur diélectrique du type en transmission ayant deux amplificateurs dans deux boucles de rétrocouplage.

La figure 2 représente un oscillateur à résonateur diélectrique du type en réflexion qui comprend deux éléments actifs 20 et 22 et un résonateur diélectrique 24.

Chaque élément actif est associé au résonateur 24 par un couplage par réflexion. Une onde émise par un élément actif est réfléchie par le résonateur et est renvoyée vers l'élément actif qui l'amplifie. Pour obtenir l'oscillation, il est aussi nécessaire de satisfaire à deux conditions : le gain de l'élément actif doit être supérieur aux pertes, et les ondes réfléchies doivent revenir en phase avec les ondes émises. La seconde condition est satisfaite en réglant la distance entre le plan de couplage du résonateur et les ports des éléments actifs.

Dans le montage dit "push-push" représenté sur la figure 2, les oscillations créées sont en opposition de phase car le point de couplage 23 de l'élément actif 22 au résonateur 24 est diamétralement opposé au point de couplage 21 de l'élément actif 20 au résonateur 24 en forme de disque. Ces ondes en opposition de phase sont amenées à un point de sortie 32 par un combineur à lignes 28 et 30.

Dans ce genre de montage le résonateur 24 est disposé entre deux lignes micro bandes 23₁ et 24₁. Ce résonateur a pour but de permettre l'oscillation et de maintenir les signaux des deux oscillateurs en opposition de phase. On a constaté que si l'oscillation ne se produit pas exactement à la fréquence de résonance du résonateur, le maintien des oscillations en opposition de phase n'est pas effectué correctement, ce qui aboutit à fonctionnement dégradé. Dans les faits cet oscillateur est destiné à fournir une fréquence 2f₀ double de la fréquence fondamentale f₀ en tirant avantage du fait que les ondes de sortie sont en opposition de phase à la fréquence f₀, mais ne peuvent être en phase à la fréquence double. Le combineur à lignes 28 et 30 permet d'éliminer les ondes en opposition de phase et d'additionner les ondes en phase. Mais comme les caractéristiques du combineur dépendent nécessairement de la fréquence f₀, on comprend que si l'oscillation s'effectue à une fréquence différente, l'élimination de la fréquence fondamentale ne sera pas effectuée de façon complète.

On peut aussi observer que le résonateur 24 devant être disposé exactement de façon symétrique par rapport aux lignes 23₁ et 24_{1,} son positionnement n'est pas aisé, ce qui est particulièrement gênant, notamment pour des fabrications en série. En outre, il nécessite des réglages manuels, notamment de l'impédance 34 reliant une électrode de l'élément actif 20 ou 22 à la masse. Toutefois, l'avantage de ce montage est qu'il présente un faible bruit de phase.

L'invention a pour but de fournir un oscillateur hyperfréquence, délivrant une onde à fréquence 2f₀ à l'aide d'un résonateur à fréquence f₀, qui puisse être réalisé d'une façon simple et dont les paramètres de fonctionnement sont peu sensibles aux réglages.

L'oscillateur conforme à l'invention comporte au moins deux éléments actifs coopérant en transmission avec un même résonateur diélectrique, le montage étant tel que l'entrée et la sortie de chaque élément actif soient en opposition de phase à la fréquence de résonance du résonateur et que l'entrée de deux éléments actifs voisins sont connectées à un premier port couplé au résonateur diélectrique et, de même, les sorties des éléments actifs voisins sont connectées à un second port couplé au résonateur, le couplage de ces ports au résonateur étant tel que ceux-ci soient pratiquement en court-circuit.

Autrement dit c'est la présence simultanée des éléments actifs qui permet l'oscillation et les oscillations de deux oscillateurs voisins sont synchronisés avec un déphasage de 180°. Ainsi, par rapport à la structure "push-push" représentée sur la figure 2 le résonateur permet l'oscillation de l'un ou de l'autre des oscillateurs élémentaires, mais n'a pas pour rôle de maintenir un déphasage de 180°entre les signaux des deux oscillateurs. En d'autres termes, dans l'oscillateur conforme à l'invention la synchronisation des deux oscillateurs élémentaires est obtenue indépendamment du résonateur.

Il en résulte que l'oscillateur est moins sensible aux paramètres du résonateur.

Étant donné que le résonateur de l'oscillateur selon l'invention n'a pas pour but d'assurer le déphasage de 180° entre les oscillations produites par chacun des oscillateurs élémentaires, il n'est pas nécessaire que ce résonateur soit positionné exactement de façon symétrique par rapport aux premier et second ports, alors que dans l'oscillateur de circuit "push-push" de la figure 2, il est nécessaire que le résonateur 24 soit symétrique par rapport aux lignes 23₁ et 24₁. Ainsi, l'invention permet des découplages différents entre, d'une part, le premier port et le résonateur et, d'autre part, le second port et le résonateur.

On remarquera aussi que, pour obtenir l'opposition de phase entre les ondes fournies par chacun des éléments actifs, il n'est pas nécessaire de prévoir un combineur dont les longueurs des lignes dépendent de λ, comme c'est le cas dans le montage "push-push" de la figure 2. Le circuit associé peut donc présenter une largeur de bande de fréquences plus importante que les montages connus tels que ceux représentés sur les figures 1 et 2.

En outre, on notera que, par rapport à un oscillateur comportant un seul élément actif et associé en transmission à un résonateur diélectrique (figure 1), le court-circuit est obtenu sans qu'il soit nécessaire de prévoir une ligne ayant une longueur d'un quart de longueur d'onde.

Au surplus, par rapport au montage "push-push", le fait qu'un combineur ne soit pas nécessaire simplifie la mise au point de l'oscillateur.

L'invention concerne de façon générale un oscillateur hyperfréquence selon l'une ou l'autre des revendications 1 ou 2.

Dans une réalisation, les ondes dans les lignes aboutissant au premier point de couplage sont en opposition de phase et, de même, les ondes dans les lignes aboutissant au second point de couplage sont en opposition de phase.

Les éléments actifs peuvent être pratiquement identiques et les longueurs des lignes reliant le premier point de couplage aux entrées des éléments actifs peuvent être pratiquement égales et les longueurs des lignes reliant le second point de couplage aux sorties des éléments actifs peuvent aussi être sensiblement égales.

De préférence, l'oscillateur comporte un nombre pair d'éléments actifs associés à un résonateur unique.

Les éléments actifs comportent, par exemple, chacun un amplificateur.

Selon un mode de réalisation, le résonateur présente une forme circulaire et les points de couplage sont en des positions diamétralement opposées par rapport à ce résonateur.

La fréquence de résonance du résonateur diélectrique est choisie de façon que l'oscillateur présente par exemple, une fréquence dans la bande de 10 à 15 GHz.

L'invention concerne aussi un procédé de réalisation d'un tel oscillateur qui est caractérisé en ce qu'on part d'un élément actif et d'un résonateur, en ce qu'on connecte une ligne de longueur λ/4 aux premier et second points de couplage de façon à réaliser des courts-circuits, en ce qu'on règle la distance des points de couplage au résonateur de façon telle qu'on minimise la rétroaction tout en maintenant l'oscillation obtenue avec l'élément actif, en ce qu'on enlève les lignes de longueur λ/4, et en ce qu'on installe l'autre (ou les autres) éléments(s) actif(s) au(x) point(s) de couplage.

D'autres caractéristiques et avantages de l'invention apparaîtront avec la description de certains de ses modes de réalisation, celle-ci étant effectuée en se référant aux dessins ci-annexés sur lesquels :
Les fig. 1 et 2, déjà décrites, représentent des oscillateurs connus,
La fig. 3 est un schéma d'un oscillateur conforme à l'invention et qui comporte deux éléments actifs, et
La fig. 4 est un schéma d'une autre réalisation d'oscillateur conforme à l'invention comportant quatre éléments actifs.

L'oscillateur représenté sur la figure 3 comporte deux éléments actifs 40 et 42, et un résonateur diélectrique 44. Les éléments actifs 40 et 42 sont, dans cet exemple, des amplificateurs. Le résonateur diélectrique 44 est monté en transmission dans la boucle de rétroaction de chacun des amplificateurs 40 et 42 et de façon telle que les ports de couplage 46 et 48 constituent pratiquement des masses virtuelles ou courts-circuits. Ce résonateur 44 présente, dans l'exemple, la forme d'un disque et les ports 46 et 48 sont en des positions diamétralement opposées par rapport à ce disque.

On voit ainsi que la sortie de l'amplificateur 40 est reliée, par un conducteur 50, au port 46. De même, une ligne 52 relie la sortie de l'amplificateur 42 au port 46.

De façon analogue, une ligne 54 relie l'entrée de l'amplificateur 40 au port 48 et une ligne 56 relie l'entrée de l'amplificateur 42 au port 48.

Comme déjà mentionné, pour obtenir un déphasage nul modulo 2π d'une onde traversant un amplificateur et le résonateur 44 et revenant à l'entrée du même amplificateur, il faut que cet amplificateur et les lignes associées introduisent un déphasage de π si le résonateur introduit ce même déphasage. Si le résonateur introduit un déphasage différent de π, le reste du circuit devra introduire un déphasage qui sera le complément à 2π.

Pour obtenir des courts-circuits aux ports 46 et 48, les éléments actifs 40 et 42 sont de préférence identiques et les longueurs des lignes 50 et 52 sont de préférence égales, et, de même, les longueurs des lignes 54 et 56 sont aussi de préférence égales. Toutefois, l'opposition de phase aux ports 46 et 48 entre les oscillations des deux oscillateurs élémentaires (et donc les courts-circuits à aspects) s'obtient même en l'absence d'identité entre les éléments 40 et 42 et/ou entre les longueurs des lignes, du fait de l'action d'un oscillateur élémentaire sur l'autre.

Pour la mise au point de l'un des oscillateurs représentés sur la figure 3, on peut procéder de la façon suivante :

On part tout d'abord d'un élément actif, par exemple l'élément actif 40, du résonateur 44, du port 46 et de la ligne 50 ainsi que du port 48 et de la ligne 54, l'élément actif 42 et les lignes 52 et 56 n'étant pas initialement prévus.

En outre, on installe, aux ports 46 et 48, une ligne de longueur λ/4 (non représentée) analogue à la ligne 18 de la figure 1 de façon à obtenir des courts-circuits à ces ports.

Ensuite, on ajuste les distances des ports 46 et 48 au résonateur de façon à optimiser la rétroaction.

Après cette opération on enlève les lignes de longueur λ/4. Dans ces conditions, on n'obtient plus d'oscillation.

On installe ensuite l'élément actif 42 avec les lignes 52 et 56. Les signaux des deux oscillateurs élémentaires à éléments actifs 40 et 42, se mettent alors automatiquement en opposition de phase. Les deux oscillateurs se synchronisent à 180°, c'est-à-dire forment pratiquement des courts-circuits aux ports 46 et 48, indépendamment des caractéristiques du résonateur.

L'oscillateur fonctionne au double de la fréquence de résonance du résonateur 44. Il présente une grande stabilité et un faible bruit de phase. Il ne nécessite pas de réglages manuels. Il peut donc aisément être fabriqué de façon automatique en grande série. En outre, comme déjà mentionné ci-dessus, les circuits associés peuvent être à bande relativement large. En outre, il n'est pas nécessaire de prévoir un combineur comme dans un montage "push-push" classique.

Le signal de sortie de l'oscillateur est par exemple, obtenu à l'aide d'une antenne (non montrée) couplée au boîtier contenant les éléments 40, 42 et 44.

Il peut fonctionner dans toute la gamme des hyperfréquences soit de 500 MHz à 60 GHz. Il donne des résultats particulièrement bons en bande Ku de 10 à 15 GHz. Il est utile notamment dans le domaine des télécommunications et/ou des transmissions de signaux de télévisions numériques.

Dans le mode de réalisation représenté sur la figure 4, l'oscillateur comporte un résonateur 44 auquel sont associés quatre oscillateurs élémentaires, c'est à dire quatre éléments actifs, respectivement 60, 62, 64 et 66. Ces éléments actifs sont des amplificateurs qui sont montés de façon telle que l'entrée d'un amplificateur soit reliée à l'entrée d'un amplificateur voisin par l'intermédiaire d'un port correspondant 70, 72 et la sortie de chaque amplificateur est connectée à la sortie d'un autre amplificateur voisin par l'intermédiaire de ports respectivement 74 et 76.

Ainsi, le port 70 est connecté aux entrées des amplificateurs 60 et 62 et le port 72 est connecté aux entrées des amplificateurs 64 et 66. Le port 74 est relié aux sorties des amplificateurs 60 et 66 tandis que le port 76 est relié aux sorties des amplificateurs 62 et 64.

Comme dans le montage de la figure 3, on choisit les positions des ports de façon telle que l'entrée et la sortie de chaque amplificateur soient pratiquement en opposition de phase.

En outre, le montage est tel que chaque oscillateur élémentaire fonctionne en opposition de phase avec l'oscillateur élémentaire voisin, c'est à dire que les ports 70, 72, 74, 76 constituent pratiquement des courts-circuits ou masses virtuelles. Ainsi, par exemple, l'oscillateur élémentaire à élément actif 60 produit l'oscillation en opposition de phase avec une oscillation de l'oscillateur élémentaire à élément actif 62 et en opposition de phase avec l'oscillation de l'oscillateur élémentaire à élément actif 66.

Comme dans le mode de réalisation décrit avec la figure 3, l'oscillateur à quatre éléments actifs oscille à une fréquence double de celle du résonateur. On peut noter que dans ce mode de réalisation deux oscillateurs non-adjacents sont en phase.

L'intérêt du montage de la figure 4 par rapport à celui représenté sur la figure 3 est qu'il permet, d'une part, de délivrer une plus grande puissance et, d'autre part, un bruit de phase encore plus réduit.

De façon générale, le montage peut comporter un nombre pair d'éléments actifs.

## Revendications

1. Oscillateur hyperfréquence comprenant deux éléments actifs (40, 42) et un résonateur (44) diélectrique, **caractérisé en ce que** le couplage entre chaque élément actif et le résonateur diélectrique est du type en transmission et **en ce que** les entrées des éléments actifs sont reliées à un premier point de couplage (48) au résonateur par des lignes (54, 56) et, de même, les sorties des éléments actifs sont reliées à un second point de couplage (46) au résonateur par des autres lignes (50, 52) de façon que les points de couplage au résonateur (46, 48) constituent des masses virtuelles.

2. Oscillateur hyperfréquence comprenant un nombre pair supérieur à deux éléments actifs (60, 62, 64, 66) et un résonateur (44) diélectrique, **caractérisé en ce que** le couplage entre chaque élément actif et le résonateur diélectrique est du type en transmission et **en ce que** les éléments actifs sont montés de façon telle que l'entrée de chaque élément actif soit reliée à l'entrée d'un seul élément actif voisin par l'intermédiaire d'un point de couplage au résonateur (70, 72) et la sortie de chaque élément actif est connectée à la sortie d'un seul autre élément actif voisin par l'intermédiaire d'un autre point de couplage au résonateur (74, 76) et que les points de couplage au résonateur (70, 72, 74, 76) constituent des masses-virtuelles.

3. Oscillateur selon la revendication 1, **caractérisé en ce que** les ondes dans les lignes (54,56), aboutissant au premier point de couplage (48 ; 70, 72), sont en opposition de phase et, de même, les ondes dans les lignes (50,52), aboutissant au second point de couplage (46 ; 74, 76), sont en opposition de phase.

4. Oscillateur selon l'une des revendications 1 ou 3, **caractérisé en ce qu'**il comporte un nombre pair d'éléments actifs du même type et **en ce que** les lignes reliant le premier point de couplage (48 ; 70, 72) aux entrées des éléments actifs sont du même longueur, et **en ce que** les lignes reliant le deuxième point de couplage (46 ; 74, 76) aux sorties des éléments actifs sont du même longueur

5. Oscillateur selon l'une des revendications 1 à 3, **caractérisé en ce qu'**il comporte un nombre pair d'éléments actifs associés à un résonateur unique (44).

6. Oscillateur selon l'une quelconque des revendications précédentes, **caractérisé en ce que** les éléments actifs comportent chacun un amplificateur.

7. Oscillateur selon l'une quelconque des revendications précédentes, **caractérisé en ce que** le résonateur présente une forme circulaire et **en ce que** les points de couplage (48,46) sont en des positions diamétralement opposées par rapport à ce résonateur (44).

8. Oscillateur selon l'une quelconque des revendications précédentes, **caractérisé en ce que** la fréquence de résonance du résonateur diélectrique est choisie de façon que l'oscillateur présente une fréquence dans la bande de 10 à 15 GHz.

9. Procédé de réalisation d'un oscillateur selon l'une des revendications 1, 3 ou 4 **caractérisé en ce qu'**on part d'un élément actif (40) et d'un résonateur (44), **en ce qu'**on connecte une ligne de longueur λ/4 aux premier et second points de couplage de façon à réaliser des courts-circuits, **en ce qu'**on règle la distance des points de couplage au résonateur de façon telle qu'on minimise la rétroaction tout en maintenant l'oscillation obtenue avec l'élément actif, **en ce qu'**on enlève les lignes de longueur λ/4, et **en ce qu'**on installe l'autre élément actif au point de couplage.

## Patentansprüche

1. Ultrahochfrequenz-Oszillator, bestehend aus zwei aktiven Elementen (40, 42) und einem dielektrischen Resonator (44), **dadurch gekennzeichnet, dass** die Kopplung zwischen jedem aktiven Element und dem dielektrischen Resonator zur Übertragung erfolgt und dass die Eingänge der aktiven Elemente an einem ersten Koppelpunkt (48) über die Leitungen (54, 56) mit dem Resonator verbunden sind, und dass die Ausgänge der aktiven Elemente gleichermaßen über andere Leitungen (50, 52) an einem Koppelpunkt (46) mit dem Resonator verbunden sind, so dass die Koppelpunkte am Resonator (46, 48) virtuelle Massen darstellen.

2. Ultrahochfrequenz-Oszillator, bestehend aus einer geraden Anzahl von mehr als zwei aktiven Elementen (60, 62, 64, 66) und einem dielektrischen Resonator (44), **dadurch gekennzeichnet, dass** die Kopplung zwischen jedem aktiven Element und dem dielektrischen Resonator zur Übertragung erfolgt und dass die aktiven Elemente derart aufgebaut sind, dass der Eingang jedes aktiven Elements über einen Koppelpunkt am Resonator (70, 72) mit dem Eingang eines einzigen benachbarten aktiven Elements verbunden ist, und dass der Ausgang jedes aktiven Elements über einen anderen Koppelpunkt am Resonator (74, 76) mit dem Ausgang eines einzigen benachbarten aktiven Elements verbunden ist, und dass die Koppelpunkte am Resonator (70, 72, 74, 76) virtuelle Massen darstellen.

3. Oszillator gemäß Anspruch 1, **dadurch gekennzeichnet, dass** die Wellen in den Leitungen (54, 56), die an den ersten Koppelpunkt (48; 70, 72) gelangen, in Gegenphase vorliegen und dass die Wellen in den Leitungen (50, 52), die an den zweiten Koppelpunkt (46; 74, 76) gelangen, gleichermaßen in Gegenphase vorliegen.

4. Oszillator gemäß einem der Ansprüche 1 oder 3, **dadurch gekennzeichnet, dass** er eine gerade Anzahl an aktiven Elementen gleichen Typs beinhaltet und dass die Leitungen, die den ersten Koppelpunkt (48; 70, 72) mit den Eingängen der aktiven Elemente verbinden, die gleiche Länge aufweisen, sowie dadurch, dass die Leitungen, die den zweiten Koppelpunkt (46; 74, 76) mit den Ausgängen der aktiven Elemente verbinden, die gleiche Länge aufweisen.

5. Oszillator gemäß einem der Ansprüche 1 bis 3, **dadurch gekennzeichnet, dass** er eine gerade Anzahl an aktiven Elementen beinhaltet, die an einen einzigen Resonator (44) angeschlossen sind.

6. Oszillator gemäß einem der vorgenannten Ansprüche, **dadurch gekennzeichnet, dass** die aktiven Elemente jeweils einen Verstärker beinhalten.

7. Oszillator gemäß einem der vorgenannten Ansprüche, **dadurch gekennzeichnet, dass** der Resonator eine runde Form aufweist, und dass die Koppelpunkte (48, 46) in Bezug auf diesen Resonator (44) diametral entgegengesetzt angeordnet sind.

8. Oszillator gemäß einem der vorgenannten Ansprüche, **dadurch gekennzeichnet, dass** die Resonanzfrequenz des dielektrischen Resonators so gewählt wird, dass der Oszillator eine Frequenz in einem Frequenzbereich zwischen 10 und 15 GHz aufweist.

9. Herstellungsverfahren für einen Oszillator gemäß einem der Ansprüche 1, 3 oder 4, **dadurch gekennzeichnet, dass** man von einem aktiven Element (40) und einem Resonator (44) ausgeht, dass man eine Leitung mit der Länge λ/4 an den ersten und den zweiten Koppelpunkt anschließt, um Kurzschlüsse herzustellen, dass man den Abstand zwischen den Koppelpunkten so einstellt, dass die Rückkopplung minimiert und gleichzeitig die mit dem aktiven Element erzielte Oszillation beibehalten wird, dass man die Leitungen mit der Länge λ/4 entfernt und dass man das andere aktive Element am Koppelpunkt installiert.

## Claims

1. A microwave oscillator including two active components (40, 42) and a dielectric resonator (44) **characterized in that** the coupling between each active component and the dielectric resonator is of the transmission type and **in that** inputs of active components are connected to a first point (48) coupled to the resonator by lines (54, 56) and likewise outputs of active components are connected to a second point (46) coupled to the resonator by other lines (50, 52) so that the points (46, 48) coupled to the resonator constitute virtual grounds.

2. A microwave oscillator comprising an even number greater than two active components (60, 62, 64, 66) and a dielectric resonator (44), **characterized in that** the coupling between each active component and the dielectric resonator is of the transmission type and **in that** the active components are mounted so that the input of each active component is connected to the input of a single neighbouring active component via a bridge coupled to the resonator (70, 72) and the output of each active component is connected to the output of a single other neighbouring active component via another bridge coupled to the resonator (74, 76) and so that the points coupled to the resonator (70, 72, 74, 76) constitute virtual grounds.

3. An oscillator according to claim 1 **characterized in that** the waves in the lines (54, 56) terminating at the first coupling point (48, 70, 72) are in antiphase and likewise the waves in the lines (50, 52) terminating at the second coupling point (46, 74, 76) are in antiphase.

4. An oscillator according to claim 1 or claim 3 **characterized in that** it comprises an even number of active elements of the same type, **in that** the lines connecting the first coupling point (...) to the inputs of the active elements are the same length, and **in that** the lines connecting the second coupling point (...) to the outputs of the active elements are the same length.

5. An oscillator according to any of claims 1 to 3 **characterized in that** it comprises an even number of active elements associated with a single resonator (44).

6. An oscillator according to any preceding claim **characterized in that** the active elements each comprise an amplifier.

7. An oscillator according to any preceding claim **characterized in that** the resonator is circular and **in that** the coupling points (48, 46) are at diametrally opposite positions relative to said resonator (44).

8. An oscillator according to any preceding claim **characterized in that** the dielectric resonator has a resonant frequency chosen so that said oscillator has a frequency in the band from 10 GHz to 15 GHz.

9. A method of producing an oscillator according to any of claims 1, 3, or 4 **characterized in that** it starts from an active component (40) and a resonator (44), **in that** a line of length λ/4 is connected to said first and second coupling points to provide short circuits, **in that** the distance of said coupling points from said resonator is adjusted to minimize feedback whilst maintaining the oscillation obtained with the active component, **in that** the lines of length λ/4 are removed and **in that** the other active component is installed at the coupling point.
